# EUROPÄISCHE PATENTANMELDUNG

(11) **EP 0 971 390 A1**
(43) Veröffentlichungstag der Anmeldung: **12.01.2000**
(21) Anmeldenummer: 98810635.7
(22) Anmeldetag: 07.07.1998
(51) Int. Cl.: H01L 21/00, H05K 13/00

(54) **Einrichtung zum Transportieren von integrierten Schaltungen**

(71) Anmelder: ESEC Management SA, 6330 Cham (CH); ESEC SA, CH-6330 Cham/Steinhausen (CH)
(72) Erfinder: Vischer, Dieter, 6300 Zug (CH)

(57) **Zusammenfassung**

Es wird eine neuartige Einrichtung zum Transportieren von einzelnen integrierten Schaltungen (6, 6', 6'') eines Wafers (5) beschrieben, die von einem Wafertisch (3) zu einem getakteten Transportband (2) geführt werden, wobei mittels eines Saugkopfes (4) eine integrierte Schaltung an einem fest vorgegebenen Aufnahmeort (A) vom Wafertisch abgehoben und an einem fest vorgegebenen Abgabeort (B) auf Systemträgern (11, 11', 11'',...) auf dem Transportband (2) abgelegt wird. Der Wafer (5) befindet sich zentriert über dem Mittelpunkt (M) des Wafertisches (3). Ferner ist der Wafertisch (3) in diskreten Schritten verschiebbar, um eine weitere integrierte Schaltung aufzunehmen. Damit auch grössere Wafer abgearbeitet werden können, ist der Wafertisch (3) um seinen Mittelpunkt (M) drehbar.

## Beschreibung

Die Erfindung betrifft eine Einrichtung zum Transportieren von integrierten Schaltungen nach dem Oberbegriff des Patentanspruchs 1.

Für die Herstellung von vielen elektronischen Geräten werden heutzutage eine Vielzahl von integrierten Schaltungen oder IC's eingesetzt, die auf einem Systemträger befestigt und mittels dünnen Gold- oder Aluminiumdrähten mit den einzelnen Leiterbahnen elektrisch verbunden werden. Dazu werden jeweils eine integrierte Schaltung aus einem Wafer, der auf einem in X- und Y-Richtung verschiebbaren Wafertisch angebracht ist, mittels eines Saugkopfes an einem festen Ort abgehoben und zu einem festen Ort auf einen auf einem Transportband befindlichen Systemträger abgelegt. Das Transportband wird im Takt mit der Bewegung des Saugkopfes weiterbewegt. Der Wafertisch wird nach dem Entfernen einer integrierten Schaltung aus dem Wafer um einen diskreten Schritt weiterbewegt, so dass der Saugkopf die nächste integrierte Schaltung mit einer hohen Wiederholgenauigkeit am festen Aufnahmeort abhebt und auf den nächsten Systemträger ablegt. Solche Transporteinrichtungen sind unter der Bezeichnung Die Bonder 2007 der Firma ESEC SA in CH-6330 Cham bekannt. Der Wafertisch ist nun für Wafers mit einem Durchmesser von 8 Zoll (ungefähr 20 cm) ausgelegt, so dass grössere Wafer mit der vorliegenden Einrichtung nicht mehr verarbeitet werden können.

Der vorliegenden Erfindung liegt nun die Aufgabe zugrunde, eine Einrichtung der vorgenannten Art so zu verbessern, dass auch Wafer mit einem wesentlich grösseren Durchmesser verarbeitet werden können.

Diese Aufgabe wird durch eine Transporteinrichtung mit den Merkmalen des Patentanspruchs 1 gelöst.

Die erfindungsgemässe Einrichtung hat den grossen Vorteil, dass ohne grosse bauliche Massnahmen Wafer mit einem grösseren Durchmesser, beispielsweise 12 Zoll (etwa 30 cm), nach wie vor mit derselben Präzision abgearbeitet werden können.

Weitere Vorteile der Erfindung folgen aus den abhängigen Patentansprüchen und aus der nachfolgenden Beschreibung, in welcher die Erfindung anhand eines in der schematischen Zeichnung dargestellten Ausführungsbeispieles näher erläutert wird.

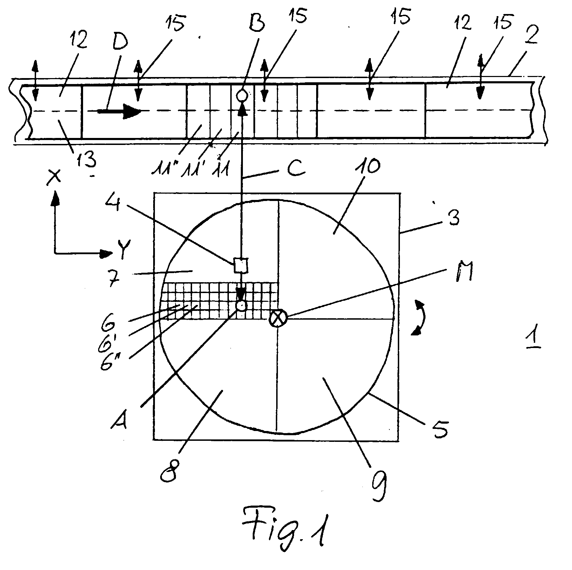

Die einzige Figur 1 zeigt eine Transporteinrichtung mit einem drehbaren Wafertisch und einem grossen Wafer.

In der Figur ist eine Transporteinrichtung 1 mit einem Transportband 2, einem um den Mittelpunkt M drehbaren Wafertisch 3 und einem hin- und her bewegbaren Saugkopf 4 dargestellt. Der Saugkopf 4 bewegt sich stets von einem festen Aufnahmeort A zu einem festen Abgabeort B, welche Hin- und Herbwegung durch einen Pfeil C dargestellt ist. Auf dem Wafertisch 3 ist ein grosser Wafer 5 mit einem Durchmesser von 12 Zoll (etwa 30 cm) angeordnet. Das Zentrum des Wafers 5 befindet sich in unmittelbarer Nähe des Mittelpunktes M des Wafertisches 3. Der Wafer 5 befindet sich also zentriert über dem Mittelpunkt M des Wafertisches 3. Um die einzelnen integrierten Schaltungen 6, 6', 6'' usw. des ersten Quadranten 7 des Wafers 5 abzuarbeiten, wird der Wafertisch 3 in bekannter Weise in diskreten Schritten in X- und Y-Richtung bewegt, damit eine neu aufzunehmende integrierte Schaltung 6' an genau denselbem Ort A, d.h. deckungsgleich mit der vorhergehend transportierten integrierten Schaltung 6, vom Saugkopf 4 abgehoben werden kann. Sobald alle intergrierten Schaltungen 6, 6', 6'' usw. des ersten Quadranten 7 abgearbeitet sind, wird der Wafertisch 3 um 90° gedreht, so dass die - hier nicht weiter gezeigten - integrierten Schaltungen 10, 10', 10'' des zweiten Quadranten 8 des Wafers 5 vom Saugkopf 4 aufgenommen und auf die auf dem Transportband 2 befindlichen Systemträger 11, 11', 11'' usw. abgelegt werden können.

Damit die integrierten Schaltungen des zweiten Quadranten 8 des Wafers 5 ebenfalls mit der richtigen Orientierung auf den Systemträgern 11, 11',11'' usw. abgelegt werden, muss der Saugkopf 4 während der Hin- und Herbewegung jeweils um 90° gedreht werden.

Um die integrierten Schaltungen, die sich im dritten und vierten Quadranten 9 bzw. 10 des Wafers befinden, abzuarbeiten, wird der Wafertisch 3 jeweils um weitere 90° gedreht. Der Saugkopf 4 seinerseits führt bei jeder Plazierung einer integrierten Schaltung eine Drehbewegung in entgegengesetzter Drehrichtung aus, um die durch die Drehung des Wafers 5 erfolgte Drehung der integrierten Schaltungen wieder rückgängig zu machen.

Selbstverständlich könnte auch zunächst die obere Hälfte des Wafers 5, d.h. der erste Quadrant 7 und der vierte Quadrant 10, abgearbeitet, dann der Wafertisch um 180° gedreht, und danach der dritte und vierte Quadrant 8 und 9 abgearbeitet werden.

Die Systemträger 11, 11', 11'' sind beispielsweise in zwei nebeneinander liegenden Streifen 12 und 13 vorgesehen, die mittels einer Greifvorrichtung, die durch einen Pfeil 15 angedeutet ist, quer zur Transportrichtung (Pfeil D) des Transportbandes 2 hin- und herbewegt werden können. Durch die Koordination der Vorwärtsbewegung des Transportbandes 2 und der Hin- und Herbewegung der Greifvorrichtung 15, die beide in diskreten Schritten von einer - hier nicht weiter dargestellten - elektronischen Steuerung vorgenommen werden, wird der jeweilige Systemträger 11, 11', 11'' usw. präzise an den Abgabeort B plaziert.

Die Systemträger 11, 11', 11'' im Streifen 13 könnten gegenüber den Systemträgern 11, 11', 11'' im Streifen 12 um 180° gedreht auf dem Transportband 2 angeordnet sein, wobei dann die integrierten Schaltungen, die sich im ersten oder im zweiten Quadranten 7 bzw. 8 befinden, auf einem Systemträger 11, 11', 11'' im Streifen 12 und die integrierten Schaltungen, die sich im dritten oder im vierten Quadranten 9 bzw. 10 befinden, auf einem Systemträger 11, 11', 11'' im Streifen 13 plaziert werden. In diesem Fall muss der Saugkopf 4 während der Hin und Herbewegung nur Drehungen um 0° oder 90° ausführen.

Es versteht sich für den Fachmann von selbst, dass die beschriebene Einrichtung jeweils zu kalibrieren ist, damit die infolge der Drehung des Wafertisches 3 erfolgte Drehung der integrierten Schaltungen vom Saugkopf 4 wieder vollständig kompensiert wird.

Denkbar ist auch, den Wafertisch 3 nicht um einen diskreten Winkel von 90° zu drehen, sondern um einen beliebigen Winkel, z.B. um 120°.

## Patentansprüche

1. Einrichtung zum Transportieren von einzelnen integrierten Schaltungen (6, 6', 6'',...) eines Wafers (5) von einem Wafertisch (3) zu einem getakteten Transportband (2), wobei mittels eines Saugkopfes (4) eine integrierte Schaltung an einem fest vorgegebenen Aufnahmeort (A) vom Wafertisch abgehoben und an einem fest vorgegebenen Abgabeort (B) auf Systemträgern (11, 11', 11'',...) auf dem Transportband (2) abgelegt wird, und der Wafertisch (3) in diskreten Schritten verschiebbar ist, um eine weitere integrierte Schaltung abzuarbeiten, dadurch gekennzeichnet, dass der Wafertisch (3) um seinen Mittelpunkt (M) drehbar ist.

2. Einrichtung nach Anspruch 1, dadurch gekennzeichnet, dass der Wafertisch (3) in diskreten Schritten um jeweils einen Winkel von annähernd 90° und/oder 180° drehbar ist.

3. Einrichtung nach Anspruch 1 oder 2, dadurch gekennzeichnet, dass der Saugkopf (4) drehbar ist, um die durch die Drehung des Wafertisches (3) erfolgte Drehung der integrierten Schaltung (6, 6',6'',...) wieder rückgängig zu machen.

4. Einrichtung nach Anspruch 3, dadurch gekennzeichnet, dass der Saugkopf (4) in diskreten Schritten um jeweils einen Winkel von annähernd 90° und/oder 180° drehbar ist.
